# EUROPEAN PATENT SPECIFICATION

(11) **EP 3 486 081 B1**
(45) Date of publication and mention of the grant of the patent: **11.08.2021**
(21) Application number: 18195539.4
(22) Date of filing: 19.09.2018
(51) Int. Cl.: B32B 5/02, B32B 7/08, B32B 37/00, F16J 15/08, H05K 9/00

(54) **CARBON NANOMATERIAL COMPOSITE SHEET AND METHOD FOR MAKING THE SAME**
KOHLENSTOFFNANOMATERIALVERBUNDFOLIE UND VERFAHREN ZUR HERSTELLUNG DAVON
FEUILLE EN COMPOSITE DE NANOMATÉRIAU DE CARBONE ET SON PROCÉDÉ DE PRODUCTION

(30) Priority: 16.11.2017 US 201715814662
(43) Date of publication of application: 22.05.2019
(73) Proprietor: The Boeing Company, Chicago, IL 60606-1596 (US)
(72) Inventor: Braley, Daniel J., Chicago, 60606-1596 (US); Karty, Janice L., Chicago, 60606-1596 (US)
(74) Representative: Witte, Weller & Partner Patentanwälte mbB

(56) References cited:
- EP-A1- 3 178 966
- EP-A1- 3 235 632
- US-A1- 2011 124 253

## Description

### FIELD

The present disclosure is generally related to composite materials and, more particularly, to a multifunctional carbon nanomaterial composite sheet including carbon nanomaterials, for example, in the form of a carbon nanomaterial structure, bonded to a porous carrier material, a composite structure including the carbon nanomaterial composite sheet, and methods for making the same.

### BACKGROUND

Aerospace vehicles are being designed and manufactured with greater percentages of composite materials. For example, composites may be used in the construction of various primary and secondary structures in aerospace applications, such as composite panels forming the airframe and/or exterior skin (e.g., fuselage, wings, etc.) of an aircraft. Use of composites may increase the strength, decrease the weight, and provide a longer service life of various components of the aerospace vehicle.

However, aerospace vehicles having composite components, such as skin panels, may require application of additional materials for lightning strike protection and/or to shield associated avionics and electronics from external electromagnetic interference. Such additional materials may undesirably increase the weight of the aerospace vehicle and increase the time and cost of production.

Accordingly, those skilled in the art continue with research and development efforts in the field of composite materials.

EP 3 235 632 A1 discloses, according to its abstract, a method for making a conductive pre-impregnated composite sheet includes the steps of joining a nanomaterial composite sheet, a fiber-reinforcing sheet and a resin system to form a combined sheet, heating the combined sheet, compacting the combined sheet, and cooling the combined sheet to form the conductive pre-impregnated composite sheet including the fiber-reinforcing sheet, and the nanomaterial composite sheet coupled to the fiber-reinforcing sheet, wherein the fiber-reinforcing sheet and the nanomaterial composite sheet are embedded in the resin system.

### SUMMARY

In an aspect, the disclosed method for manufacturing an elastomeric carbon nanomaterial composite sheet included in a composite structure, includes steps of (1) applying a layer of a carbon nanomaterial structure to a carrier layer to yield a carrier/carbon nanomaterial combination, the carrier layer comprising a porous material and a metallic coating applied to the porous material; (2) applying an elastomer material to the carrier/carbon nanomaterial combination to obtain the elastomeric carbon nanomaterial composite sheet; and including the elastomeric carbon nanomaterial composite sheet in a composite structure, wherein the composite structure is configured as a gasket.

In another aspect, the disclosed composite structure may include an elastomeric carbon nanomaterial composite sheet including a carrier layer that includes a porous material and a metallic coating applied to the porous material, a layer of a carbon nanomaterial structure applied to the carrier layer, the carbon nanomaterial structure including carbon nanomaterials, and an elastomer material, wherein the carrier layer and the carbon nanomaterial structure are impregnated with the elastomer material. The composite structure is configured as a gasket.

In one aspect, the disclosed structural assembly may include a first structural member, a second structural member spaced apart from the first structural member to define a gap therebetween, and a composite structure positioned in the gap, the composite structure including an elastomeric carbon nanomaterial composite sheet including a carrier layer that includes a porous material and a metallic coating applied to the porous material, a layer of a carbon nanomaterial structure applied to the carrier layer, the carbon nanomaterial structure including carbon nanomaterials, and an elastomer material, wherein the carrier layer and the carbon nanomaterial structure are impregnated with the elastomer material.

In one aspect, the disclosed method for joining a first structural member with a second structural member may include steps of (1) positioning a composite structure between the first structural member and the second structural member, the composite structure including an elastomeric carbon nanomaterial composite sheet including a carrier layer that includes a porous material and a metallic coating applied to the porous material, a layer of a carbon nanomaterial structure applied to the carrier layer, the carbon nanomaterial structure including carbon nanomaterials, and an elastomer material, wherein the carrier layer and the carbon nanomaterial structure are impregnated with the elastomer material; (2) connecting the first structural member to the composite structure; and (3) connecting the second structural member to the composite structure.

Other examples of the disclosed apparatus and methods will become apparent from the following detailed description, the accompanying drawings and the appended claims.

### BRIEF DESCRIPTION OF THE DRAWINGS

Fig. 1 is a flow diagram of one example of the disclosed method for making the disclosed carbon nanomaterial composite sheet;
Fig. 2 is a schematic illustration of one example of the disclosed system for making the disclosed carbon nanomaterial composite sheet;
Fig. 3 is a schematic block diagram of one example of the disclosed carbon nanomaterial composite sheet;
Fig. 4 is a schematic partial view, in section, of one example of the disclosed carbon nanomaterial composite sheet;
Fig. 5 is a schematic illustration of one example of the disclosed system for making the disclosed carbon nanomaterial composite sheet;
Fig. 6 is a schematic block diagram of one example of the disclosed composite structure including the disclosed carbon nanomaterial composite sheet;
Fig. 7 is a block diagram of aircraft production and service methodology;
Fig. 8 is a schematic illustration of an aircraft;
Fig. 9 is a schematic partial view, in section, of one example of the disclosed carbon nanomaterial composite sheet;
Fig. 10 is a graph showing shielding effectiveness of various examples of the disclosed carbon nanomaterial composite sheet;
Fig. 11 is a side elevational view, in cross-section, of one example of the disclosed structural assembly;
Fig. 12 is a side elevational view, in cross-section, of the composite structure of the structural assembly of Fig. 11;
Fig. 13 is a schematic representation of one elastomeric carbon nanomaterial composite sheet of the plurality of elastomeric carbon nanomaterial composite sheets forming the composite structure of Fig. 12;
Fig. 14 is a flow diagram depicting of one example of the disclosed method for manufacturing an elastomeric carbon nanomaterial composite sheet;
Fig. 15 is a schematic illustration of a process for applying elastomer material in accordance with the method of Fig. 14; and
Fig. 16 is a flow diagram depicting one example of the disclosed method for joining a first structural member with a second structural member.

### DETAILED DESCRIPTION

The following detailed description refers to the accompanying drawings, which illustrate specific examples described by the disclosure. Other examples having different structures and operations do not depart from the scope of the present disclosure. Like reference numerals may refer to the same feature, element or component in the different drawings.

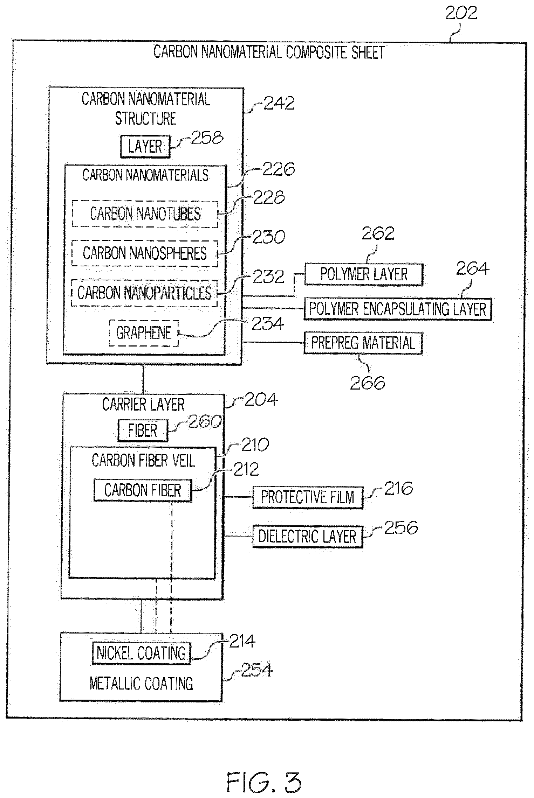

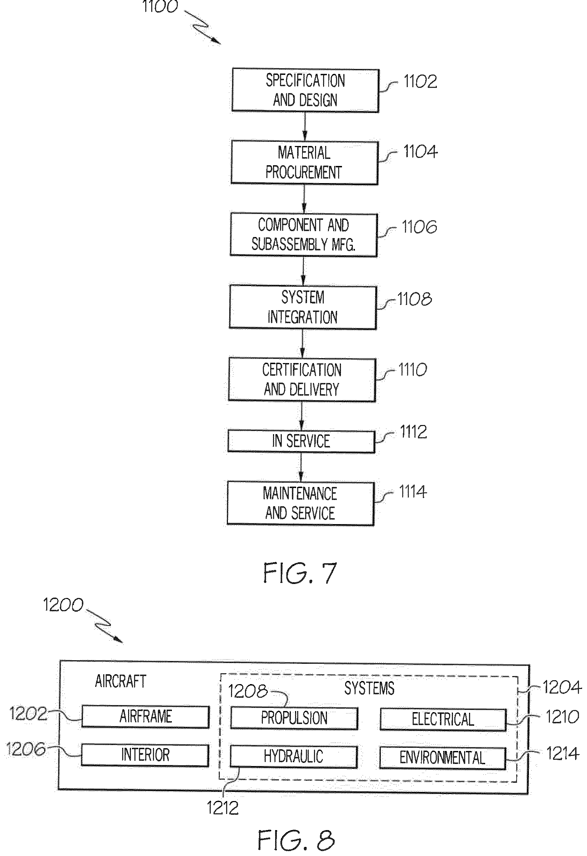

In Figs. 3 and 8, referred to above, solid lines, if any, connecting various elements and/or components may represent mechanical, electrical, fluid, optical, electromagnetic and other couplings and/or combinations thereof. As used herein, "coupled" means associated directly as well as indirectly. For example, a member A may be directly associated with a member B, or may be indirectly associated therewith, e.g., via another member C. It will be understood that not all relationships among the various disclosed elements are necessarily represented. Accordingly, couplings other than those depicted in the block diagrams may also exist. Dashed lines, if any, connecting blocks designating the various elements and/or components represent couplings similar in function and purpose to those represented by solid lines; however, couplings represented by the dashed lines may either be selectively provided or may relate to alternative examples disclosed by the present disclosure. Likewise, elements and/or components, if any, represented with dashed lines, indicate alternative examples disclosed by the present disclosure. One or more elements shown in solid and/or dashed lines may be omitted from a particular example without departing from the scope of the present disclosure. Environmental elements, if any, are represented with dotted lines. Virtual (imaginary) elements may also be shown for clarity. Those skilled in the art will appreciate that some of the features illustrated in Figs. 3 and 8 may be combined in various ways without the need to include other features described in Figs. 3 and 8, other drawing figures, and/or the accompanying disclosure, even though such combination or combinations are not explicitly illustrated herein. Similarly, additional features not limited to the examples presented, may be combined with some or all of the features shown and described herein.

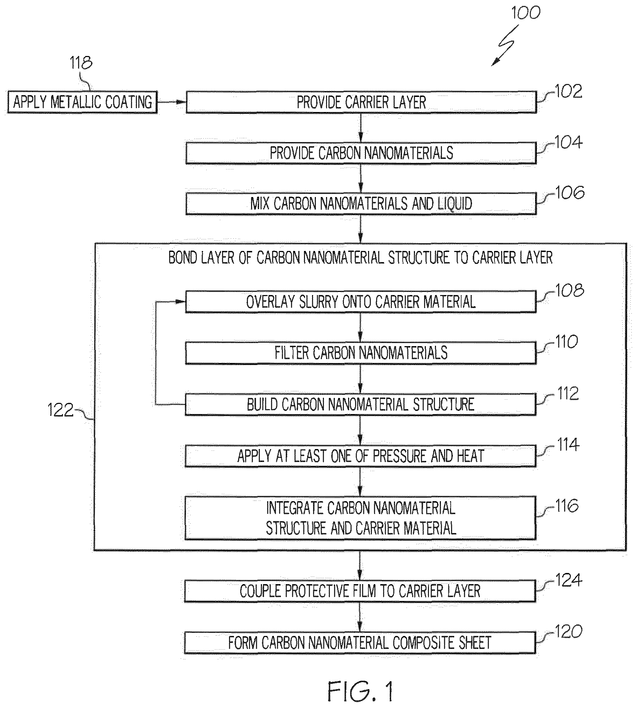

In Figs. 1 and 7, referred to above, the blocks may represent operations and/or portions thereof and lines connecting the various blocks do not imply any particular order or dependency of the operations or portions thereof. Blocks represented by dashed lines indicate alternative operations and/or portions thereof. Dashed lines, if any, connecting the various blocks represent alternative dependencies of the operations or portions thereof. It will be understood that not all dependencies among the various disclosed operations are necessarily represented. Figs. 1 and 7 and the accompanying disclosure describing the operations of the method(s) set forth herein should not be interpreted as necessarily determining a sequence in which the operations are to be performed. Rather, although one illustrative order is indicated, it is to be understood that the sequence of the operations may be modified when appropriate. Accordingly, certain operations may be performed in a different order or simultaneously. Additionally, those skilled in the art will appreciate that not all operations described need be performed.

Unless otherwise indicated, the terms "first," "second," etc. are used herein merely as labels, and are not intended to impose ordinal, positional, or hierarchical requirements on the items to which these terms refer. Moreover, reference to a "second" item does not require or preclude the existence of lower-numbered item (e.g., a "first" item) and/or a higher-numbered item (e.g., a "third" item).

As used herein, the phrase "at least one of', when used with a list of items, means different combinations of one or more of the listed items may be used and only one of the items in the list may be needed. The item may be a particular object, thing, or category. In other words, "at least one of' means any combination of items or number of items may be used from the list, but not all of the items in the list may be required. For example, "at least one of item A, item B, and item C" may mean item A; item A and item B; item B; item A, item B, and item C; or item B and item C. In some cases, "at least one of item A, item B, and item C" may mean, for example and without limitation, two of item A, one of item B, and ten of item C; four of item B and seven of item C; or some other suitable combination.

Reference herein to "example," "one example," "another example," or similar language means that one or more feature, structure, element, component or characteristic described in connection with the example is included in at least one embodiment or implementation. Thus, the phrases "in one example," "as one example," and similar language throughout the present disclosure may, but do not necessarily, refer to the same example. Further, the subject matter characterizing any one example may, but does not necessarily, include the subject matter characterizing any other example.

Illustrative, non-exhaustive examples, which may be, but are not necessarily, claimed, of the subject matter according the present disclosure are provided below.

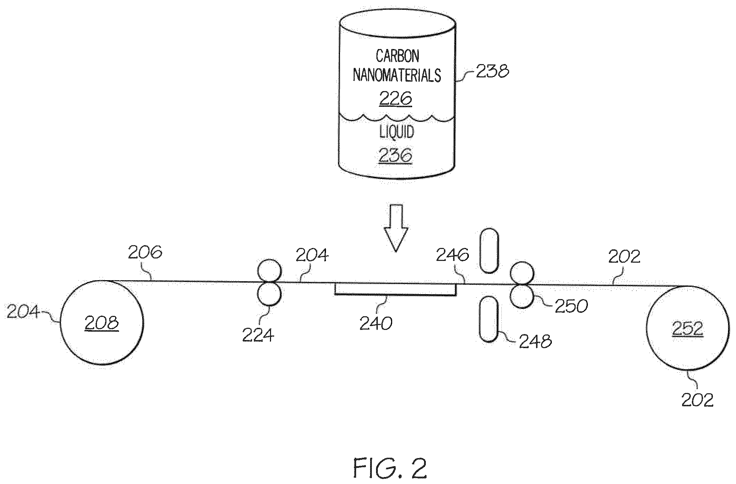

Referring to Fig. 1, one example of method 100 is disclosed. Method 100 is one example implementation of the disclosed method for making a multifunctional carbon nanomaterial composite sheet 202. As illustrated in Fig. 2, system 200 is one example implementation of the disclosed system for making carbon nanomaterial composite sheet 202, for example, according to method 100. Modifications, additions, or omissions may be made to method 100 without departing from the scope of the present disclosure. Method 100 may include more, fewer, or other steps. Additionally, steps may be performed in any suitable order.

Referring to Fig. 1, and with reference to Fig. 3, in one example, method 100 includes the step of bonding layer 258 (e.g., one or more layers) of carbon nanomaterial structure 242 to carrier layer 204, as shown at block 122. In one example, carrier layer 204 is fabricated from a porous metalized nonwoven material. In one example, layer 258 of carbon nanomaterial structure 242 is permanently bonded to carrier layer 204.

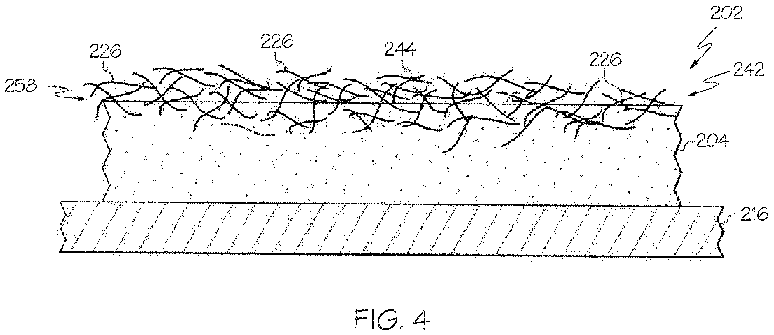

In one example, method 100 includes the step of coupling releasable protective film 216 to carrier layer 204, as shown at block 124. In one example, carrier layer 204 is located between protective film 216 and carbon nanomaterial structure 242 (e.g., layer 258 of carbon nanomaterial structure 242, as illustrated in Fig. 4.

Referring to Fig. 1, and with reference to Fig. 3, in one example implementation, method 100 includes the step of providing carrier layer 204, as shown at block 102. Generally, carrier layer 204 includes any material upon which carbon nanomaterials 226 may be overlayed to form (e.g., build and/or bond) carbon nanomaterial structure 242 on a surface of carrier layer 204. Carrier layer 204 may also be referred to as a carrier material, a material layer, a filter layer, or a filtering layer. As one general example, carrier layer 204 includes any porous material to which carbon nanomaterials 226 (e.g., slurry 238 of carbon nanomaterials 226) can be filtered through. The porous material may include an aperture or porous film, sheet, veil, or fabric material (e.g., a material having a plurality of apertures or opening through which slurry 238 is filtered). Carrier layer 204 may be conductive or non-conductive depending on a particular application and/or desired properties. Non-limiting examples include woven or nonwoven (e.g., wet-laid or melt spun) nylon, polyester, PEEK, PEKK, fiberglass, carbon fiber, metallized polymer, or metal meshes/foils (e.g., expanded copper foil).

Referring to Fig. 3, in one example, carbon nanomaterial composite sheet 202 includes layer 258 of carbon nanomaterial structure 242, and carrier layer 204. In one example, carrier layer 204 includes a porous metalized nonwoven material. In one example, carrier layer 204 is bonded to carbon nanomaterial structure 242.

Referring to Fig. 3, as one example, carbon nanomaterial composite sheet 202 is a laminate. As one example, carbon nanomaterial composite sheet 202 is a continuous sheet. As one example, carrier layer 204 is permanently bonded to the carbon nanomaterial structure 242 (e.g., to layer 258 of carbon nanomaterial structure 242). As one example, carbon nanomaterial structure 242 includes a randomly oriented, uniformly distributed structure of carbon nanotubes ("CNTs") 228. As one specific, non-limiting example, carbon nanomaterial structure 242 has a basis weight of approximately 1 gram of carbon nanomaterial 226 per square meter (gsm). As another specific, non-limiting example, carbon nanomaterial structure 242 has a basis weight of at least 1 gram of carbon nanomaterial 226 per square meter (gsm). In one example, carbon nanomaterial composite sheet 202 includes at least one polymer layer 262 coupled to carbon nanomaterial structure 242. In another example, carbon nanomaterial composite sheet 202 includes at least one polymer encapsulating layer 264 coupled to carbon nanomaterial structure 242. As one example, carbon nanomaterial composite sheet 202 includes prepreg material 266 coupled to carbon nanomaterial structure 242.

Referring to Fig. 2, and with reference to Fig. 3, on one example implementation, and as illustrated in Fig. 2, carrier layer 204 may be provided as (or take the form of) a continuous sheet of carrier layer 204 (generally referred to herein as sheet 206). As used here, "continuous" means an elongated sheet having a length that is orders of magnitude greater than a width. Generally, sheet 206 may be or may include a continuous cloth; fabric; veil; nonwoven sheet, ply, or mat; woven sheet, ply, or mat; and the like. Carrier layer 204 may be porous. Carrier layer 204 may be conductive or non-conductive. As illustrated in Fig. 2, as one example, system 200 may include a roll of carrier layer 204 (generally referred to herein as roll 208). For instance, a continuous sheet 206 may be fabricated and rolled into roll 208.

Referring to Fig. 3, and with reference to Figs. 2 and 4, as one general, non-limiting example, carrier layer 204 may be (or may take the form of) a porous, nonwoven veil, sheet, ply, or mat of conductive material. As one general example, carrier layer 204 may include fiber 260 looped together to form a thin nonwoven sheet, ply, or mat. As one specific, non-limiting example, carrier layer 204 (e.g., conductive carrier material) is (or takes the form of) carbon fiber veil 210. Thus, sheet 206 (Fig. 2) may be a continuous sheet of carbon fiber veil 210. Carbon fiber veil 210 includes carbon fiber 212 (e.g., a plurality of continuous strands of carbon fibers) that are randomly looped together to form a thin nonwoven sheet, ply, or mat of carbon fibers 212. Carbon fiber veil 210 may be porous. Carbon fiber veil 210 may also be conductive. In certain example implementations, carbon fibers 212 may be held together with a light binder (not explicitly illustrated).

As another general, non-limiting example, carrier layer 204 may be (or may take the form of) a porous, nonwoven veil, sheet, ply, or mat of non-conductive material. As specific, non-limiting examples, carrier layer 204 (e.g., non-conductive carrier material) may be (or may take the form of) a porous, nonwoven veil, sheet, ply, or mat of glass fibers (e.g., E-glass, S-glass), aramid fibers (e.g., Kevlar), fluoropolymer fibers (e.g., Ultra High Molecular Weight Polyethylene, High Density Polyethylene, Teflon, etc.) or a combination thereof.

As another general, non-limiting example, carrier layer 204 may be (or may take the form of) a porous, nonwoven veil, sheet, ply, or mat of dielectric material (e.g., a dielectric veil) (not explicitly illustrated). As specific, non-limiting examples, carrier layer 204 (e.g., dielectric carrier material) includes, but is not limited to, Ultra High Molecular Weight Polyethylene ("UHMWPE"), fluoropolymers, polyimides, or a combination thereof.

The particular materials used for carrier layer 204 may depend, at least in part, on the particular application and/or function of the disclosed carbon nanomaterial composite sheet 202, such as, but not limited to, electromagnetic interference ("EMI") shielding, lightning protection, environmental protection, environmental isolation, scratch resistance, etc. As one example, when a higher conductivity of carbon nanomaterial composite sheet 202 is desired or required, for example, for lightning strike protection and/or low frequency shielding effectiveness, carrier layer 204 may be made from a conductive material, for example, carbon fibers 212 (e.g., carbon fiber veil 210). As another example, when a lower conductivity of carbon nanomaterial composite sheet 202 is desired or required, carrier layer 204 may be made from a non-conductive material, for example, glass, aramid, and/or fluoropolymer fibers.

Referring to Fig. 3, in one example, carrier layer 204 includes a nickel-coated fiber (fiber 260 coated with nickel coating 214). Thus, in one example, carrier layer 204 includes metallic coating 254. Carrier layer 204 including metallic coating 254 may also be referred to as a metallic coated carrier layer, a metalized carrier layer, a metallic coated carrier material, a metalized carrier material, a metallic coated material layer, a metalized material layer, a metallic coated filter layer, a metalized filter layer, a metallic coated filtering layer, a metalized filtering layer, a metallic coated fiber layer, or a metalized fiber layer. As one specific, non-limiting example, metallic coating 254 is nickel coating 214. Carrier layer 204 including nickel coating 214 may also be referred to as a nickel ("Ni")-coated carrier layer, a nickel ("Ni")-metalized carrier layer, a nickel-coated carrier material, a nickel-metalized carrier material, a nickel coated material layer, a nickel-metalized material layer, a nickel coated filter layer, a nickel-metalized filter layer, a nickel coated filtering layer, a nickel-metalized filtering layer, a nickel coated fiber layer, or a nickel-metalized fiber layer.

Other metals besides nickel may also be used as metallic coating 254. The particular metal used for metallic coating 254 may be selected, for example, based on a desired shielding effectiveness.

Referring to Fig. 1 and with reference to Fig. 3, in one example implementation, method 100 may include the step of applying metallic coating 254 (e.g., nickel coating 214) to carrier layer 204, as shown at block 118 (Fig. 2). Metallic coating 254 (e.g., nickel coating 214) may be applied to carrier layer 204 by a variety of known processes or techniques. In one example implementation, nickel (nickel coating 214) may be applied to carrier layer 204 by a chemical vapor deposition process. In another example implementation, nickel may be applied to carrier layer 204 by an electroless nickel plating process. In yet another example implementation, nickel may be applied to carrier layer 204 by a nickel electroplating process.

As one example, carbon fiber veil 210 includes metallic coating 254 (e.g., nickel coating 214). Carbon fiber veil 210 including metallic coating 254 may also be referred to as a metallic coated carbon fiber veil or a metalized carbon fiber veil. As one example, nickel may be applied to carbon fiber veil 210 to form a nickel coated carbon fiber veil. Carbon fiber veil 210 including nickel coating 214 may also be referred to as a nickel coated carbon fiber veil or a nickel-metalized carbon fiber veil. Metallic coating 254 (e.g., nickel coating 214) may be applied to carbon fiber veil 210 by a variety of known processes or techniques. As examples, nickel (nickel coating 214) may be applied to carbon fiber veil 210 by a chemical vapor deposition process, an electroless nickel plating process, or a nickel electroplating process.

As one example, fiber 260 includes metallic coating 254 (e.g., nickel coating 214. As one example, metal (e.g., nickel) may be applied to individual ones of fiber 260 to form metal (e.g., nickel) coated fiber. The nickel coated fiber may be used to form fiber veil, sheet, ply, or mat (e.g., nickel coated veil, sheet, ply, or mat). An another example, carbon fiber 212 includes metallic coating 254 (e.g., nickel coating 214). As one example, metal (e.g., nickel) may be applied to individual ones of carbon fiber 212 to form metal (e.g., nickel) coated carbon fibers. The nickel coated carbon fiber may be used to form carbon fiber veil 210 (e.g., nickel coated carbon fiber veil). Metallic coating 254 (e.g., nickel coating 214) may be applied to fiber 260 or carbon fiber 212 by a variety of known processes or techniques. As examples, nickel may be applied to fiber 260 or carbon fiber 212 by a chemical vapor deposition process, an electroless nickel plating process, or a nickel electroplating process.

As one example, a non-conductive carrier material or a dielectric carrier material (e.g., carrier layer 204 made from a non-conductive material or dielectric material) includes metallic coating 254 (e.g., nickel coating 214). Application of metallic coating 254 (e.g., nickel coating 214) to the non-conductive carrier material or the dielectric carrier material may provide or essentially create a conductive carrier layer 204. For example, metal (e.g., nickel) may be applied to the non-conductive carrier material or the dielectric carrier material to form a metal coated (e.g., nickel coated) carrier material. Metallic coating 254 (e.g., nickel coating 214) may be applied to the non-conductive carrier material or the dielectric carrier material by a variety of known processes or techniques. As examples, nickel may be applied to the non-conductive carrier material or the dielectric carrier material by a chemical vapor deposition process, an electroless nickel plating process, or a nickel electroplating process.

Referring to Fig. 2, in one example, system 200 may include one or more first rollers 224. First rollers 224 may be guide rollers, nip rollers, pinch rollers or the like configured to pull, for example, sheet 206, of carrier layer 204 (e.g., carbon fiber veil 210) off of roll 208 and direct or guide carrier layer 204 along a processing path.

Referring to Fig. 1, and with reference to Figs. 2 and 3, in one example implementation, method 100 includes the step of providing carbon nanomaterials 226, as shown at block 104. Carbon nanomaterials 226 may take various forms. As illustrated in Fig. 3, as one general, non-limiting example, carbon nanomaterials 226 may be (or take the form of) carbon nanoparticles 232 having various geometries. As one specific, non-limiting example, carbon nanomaterials 226 may be (or take the form of) carbon nanotubes 228. As one specific, non-limiting example, carbon nanomaterials 226 may be (or take the form of) carbon nanospheres 230. As one specific, non-limiting example, carbon nanomaterials 226 may be (or take the form of) graphene 234. As one specific, non-limiting example, carbon nanomaterials 226 may be at least one of or a combination of carbon nanoparticles 232, carbon nanotubes 228, carbon nanospheres 230, and/or graphene 234. Carbon nanomaterials 226 may also include various other allotropes of carbon.

Various known chemical processes may be used to create carbon nanomaterials 226. For example, various types of carbon nanotubes 228, manufactured in accordance with known techniques, may be used as carbon nanomaterials 226. In one example implementation, carbon nanotubes 228 may be grown on a stainless steel sheet. Grown carbon nanotubes 228 may then be scraped away from the sheet.

As one example, carbon nanotubes 228 may be single wall carbon nanotubes ("SWCNTs"). As another example, carbon nanotubes 228 may be multiwall carbon nanotubes ("MWCNTs"). As another example, carbon nanotubes 228 may be prestressed multiwall carbon nanotubes ("PSMWCNTs"). As yet another example, carbon nanotubes 228 may be a combination of SWCNTs, MWCNTs, and/or PSMWCNTs. PSMWCNTs may be made in accordance with known techniques. As one example, PSMWCNTs may be achieved by putting MWCNTs into a bomb chamber and using an explosion to rapidly increase the pressure to force the walls of the MWCNTs to compress to within a distance where van der Waals forces dominate. As one example, PSMWCNTs may be achieved by exposing MWCNTs to radiation to increase pressure. In one particular, non-limiting example, PSMWCNTs may have an interwall spacing ranging from approximately 0.22 nm to approximately 0.28 nm (e.g., compared to approximately 0.34 nm for conventional MWCNTs). Benefits offered by PSMWCNTs may include enhanced interwall shear strengths, which in turn improve load-transfer capabilities compared to those of normal MWCNTs. This provides axial tensile strength and Young's modulus that are approximately 20 percent higher than those of normal carbon nanotubes ("CNTs").

Referring to Fig. 1, and with reference to Fig. 2, in one example implementation, method 100 includes the step of mixing carbon nanomaterials 226 and liquid 236 to form a slurry of carbon nanomaterials 226 and liquid 236 (generally referred to herein as slurry 238) (e.g., a fluid mixture or suspension of carbon nanomaterials 226 suspended in liquid 236), as shown at block 106. Liquid 236 may be any suitable dispersive liquid or fluid carrier material into which carbon nanomaterials 226 may be dispersed and suspended. Generally, liquid 236 may be non-reactive with carbon nanomaterials 226 (e.g., carbon nanomaterials 226 are insoluble in liquid 236). As one specific, non-limiting example, liquid 236 may be water. As another specific, non-limiting example, liquid 236 may be an organic solvent. As another specific, non-limiting example, liquid 236 may be an acid. As another specific, non-limiting example, liquid 236 may be a resin (e.g., a thermoplastic or epoxy). Other examples of a suitable dispersive liquid (e.g., liquid 236) are also contemplated. Liquid 236 may also include one or more compounds for improving and/or stabilizing the dispersion and suspension of carbon nanomaterials 226 in liquid 236.

Referring to Fig. 1, and with reference to Figs. 2 and 3, in one example implementation, method 100 includes the step of overlaying (e.g., dispensing) slurry 238 of carbon nanomaterials 226 and liquid 236 over carrier layer 204, as shown at block 108. Method 100 includes the step of filtering carbon nanomaterials 226 by carrier layer 204, as shown at block 110. Method 100 includes the step of forming (e.g., building) carbon nanomaterial structure 242 (Fig. 3) on a surface of carrier layer 204, as shown at block 112. The combination of carbon nanomaterial structure 242 bonded to (e.g., formed on and coupled to) carrier layer 204 may be referred to herein, and illustrated in Fig. 2, as carbon nanomaterial precursor composite sheet 246.

Referring to Figs. 2, and with reference to Fig. 3, in one example, system 200 includes forming table 240. Interaction between carbon nanomaterials 226 and carrier layer 204 to build carbon nanomaterial structure 242 (Fig. 3) occurs on forming table 240. In one example implementation, forming table 240 may include a wire mesh or screen sufficient to support carrier layer 204 when slurry 238 is dispensed (e.g., poured, sprayed, etc.) over carrier layer 204. As slurry 238 is overlayed (e.g., poured) over carrier layer 204, slurry 238 spreads out over the surface of carrier layer 204. Liquid 236 passes through carrier layer 204 and carbon nanomaterials 226 are filtered (e.g., sifted out and retained) by carrier layer 204 (e.g., on and/or at least partially below the surface of carrier layer 204) to form carbon nanomaterial structure 242. In one example implementation, carrier layer 204 is supported on a conveyer (e.g., a conveyor belt) (not explicitly illustrated), which carries carrier layer 204 along the processing path. The conveyor may be a wire mesh or screen sufficient to support carrier layer 204 in a plane as slurry 238 is dispensed over and filtered by carrier layer 204. In one example, system 200 (e.g., forming table 240) may also include a vacuum zone configured to provide a vacuum pressure sufficient to draw slurry 238 from above (e.g., from an upper surface of) carrier layer 204 and through carrier layer 204, while allowing carbon nanomaterials 226 to entangle upon the surface and settle into (e.g., at least partially disperse through) carrier layer 204. Carbon nanomaterials 226 may be randomly oriented and uniformly-distributed upon carrier layer 204 following the filtering step (block 110).

Referring to Figs. 3 and 4, and with reference to Figs. 1 and 2, in one example, at least some of carbon nanomaterials 226 are interspersed through a thickness of carrier layer 204 and are entangled with carrier layer 204 such that carbon nanomaterial structure 242 is permanently bonded to carrier layer 204, as illustrated in Fig. 4. In one example implementation, during the overlaying step (block 108) and the filtering step (block 110) (Fig. 1) of slurry 238 (Fig. 2), carbon nanomaterials 226 may become entangled with each other in multiple directions to form carbon nanomaterial structure 242 (e.g., a buildup of carbon nanomaterials 226) on the surface of carrier layer 204 (block 112). Thus, carbon nanomaterial structure 242 is a sheet structure that includes an entangled network of carbon nanomaterials 226 (e.g., a carbon nanoparticle structure includes an entangled network of carbon nanoparticles 232, a carbon nanotube structure includes an entangled network of carbon nanotubes 228, a carbon nanosphere structure includes an entangled network of carbon nanospheres 230, or a graphene structure includes an entangled network of graphene 234). Carbon nanomaterials 226 may be randomly distributed or oriented on the surface of carrier layer 204. Alternatively, carbon nanomaterials 226 may be uniformly distributed or oriented on the surface of carrier layer 204.

As one specific, non-limiting example implementation, carrier layer 204 (e.g., carbon fiber veil, nickel coated carbon fiber veil, etc.) moves along the processing path (not explicitly identified) of system 200, for example, on the conveyor. Carbon nanomaterials 226 may be applied as slurry 238 of liquid 236 and carbon nanomaterials 226 (e.g., carbon nanotubes 228, carbon nanospheres 230, carbon nanoparticles 232, graphene 234) upon carrier layer 204. The speed at which carrier layer 204 (e.g., the conveyer) moves may be controlled to provide a uniform distribution of slurry 238, and, thus, carbon nanomaterials 226, across the underlying carrier layer 204.

The density of carbon nanomaterials 226 built up to form carbon nanomaterial structure 242 may depend upon various factors including, but not limited to, the size and/or geometry of carbon nanomaterials 226, the type of carbon nanomaterials 226, a particular application of carbon nanomaterial structure 242 (e.g., a desired shielding effectiveness or attenuation at particular RF frequencies, a desired level of lightning strike protection, a desired conductivity level, a desired surface resistivity, and the like), a desired thickness of carbon nanomaterial structure 242, a desired weight of carbon nanomaterial structure 242, and the like. As one specific, non-limiting example, carbon nanomaterials 226 may have a basis weight of approximately 1 gram per square meter (gsm). As one specific, non-limiting example, carbon nanomaterials 226 may have a relative density of less than approximately 1.0. As illustrated in Fig. 1, the dispensing (block 108) and filtering (block 110) steps may be repeated as needed to build carbon nanomaterial structure 242.

Referring to Fig. 4, as one example, entanglement between carbon nanomaterials 226 may occur at various crossover locations 244 between different ones of carbon nanomaterials 226. The network of entangled carbon nanomaterials 226 may include a sufficient amount of carbon nanomaterials 226 to provide a sufficient number of crossover locations 244 to achieve a stable carbon nanomaterial structure 242.

Depending upon the type and/or geometry of carbon nanomaterials 226 (e.g., carbon nanotubes, 228, carbon nanospheres 230, carbon nanoparticles 232, graphene 234, etc.), the size of carbon nanomaterials 226 may vary. As one specific, non-limiting example, carbon nanotubes 228 may have an extremely high aspect ratio (length to diameter ratio), for example, of at least 2,500:1. For instance, carbon nanotubes 228 may have a length ranging from approximately 0.5 millimeter to approximately 4 millimeters and a diameter ranging from approximately 1 nanometer to approximately 50 nanometers. Other suitable dimensions of carbon nanomaterials 226 are also contemplated without limitation.

Due to the small size of carbon nanomaterials 226, at least some carbon nanomaterials 226 may at least partially disperse and integrate throughout carrier layer 204. For example, at least some carbon nanomaterials 226 may penetrate and intersperse at least partially through a thickness (e.g., a through-thickness) (not explicitly identified) of carrier layer 204 and entangle and integrate with carrier layer 204. Accordingly, carbon nanomaterial structure 242 is effectively coupled to carrier layer 204 (e.g., forming carbon nanomaterial precursor composite sheet 246) following the filtering (block 110) and building (block 112) steps of method 100 (Fig. 1). As one example, carbon nanomaterials 226 may be concentrated proximate (e.g., at or near) the surface of carrier layer 204. As one example, carbon nanomaterials 226 may be partially interspersed and entangled throughout the thickness of carrier layer 204. As one example, carbon nanomaterials 226 may be completely interspersed and entangled throughout the thickness of carrier layer 204.

Referring to Fig. 1, and with reference to Fig. 2, in one example implementation, method 100 includes the step of applying at least one of pressure and heat to carbon nanomaterial precursor composite sheet 246 (e.g., applying at least one of pressure and heat to the coupled combination of carbon nanomaterial structure 242 and carrier layer 204), as shown at block 114, integrating carbon nanomaterial structure 242 and carrier layer 204, as shown at block 116, and forming carbon nanomaterial composite sheet 202, as shown at block 120. The step of applying at least one of pressure and heat to carbon nanomaterial precursor composite sheet 246 (e.g., to carbon nanomaterial structure 242 and carrier layer 204) may also be referred to as laminating. As one example, applying heat may include drying carbon nanomaterial precursor composite sheet 246. For example, heat may be applied to carbon nanomaterial precursor composite sheet 246 sufficient to dry (e.g., evaporate) any remaining liquid 236 from carrier layer 204 and/or carbon nanomaterial structure 242. As one general, non-limiting example, carbon nanomaterial precursor composite sheet 246 may be heated to between approximately 200 °F and approximately 300 °F (e.g., 220 °F) to remove liquid 236 and dry carbon nanomaterial precursor composite sheet 246 and form carbon nanomaterial composite sheet 202. As one example, applying pressure may include compressing carbon nanomaterial precursor composite sheet 246. For example, pressure may be applied to carbon nanomaterial precursor composite sheet 246 sufficient to compress carbon nanomaterial precursor composite sheet 246 and form carbon nanomaterial composite sheet 202. As one general, non-limiting example, carbon nanomaterial precursor composite sheet 246 may be compressed from a thickness of approximately 8 mils to form carbon nanomaterial composite sheet 202 having a thickness of approximately 6 mils (e.g., 6.3 mils). Applying heat, pressure, or a combination thereof further bonds and integrates carbon nanomaterial structure 242 and carrier layer 204 together. The pressure and/or heat applied to carbon nanomaterial precursor composite sheet 246 (e.g., by nip rollers 250) may be uniform and aids in creating a uniform and unitary carbon nanomaterial composite sheet 202.

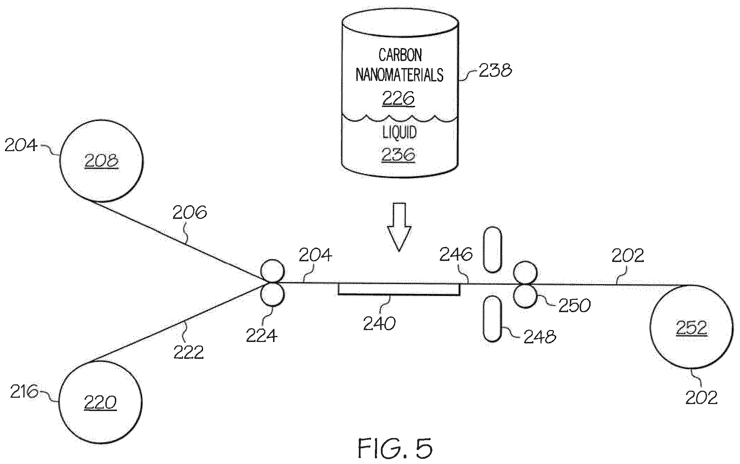

Referring to Fig. 2, and with reference to Fig. 1, system 200 may include one or more dryers 248 (e.g., to apply heat) and/or one or more second rollers 250 (e.g., to apply pressure or pressure and heat). Dryers 248 may be located proximate (e.g., near) carbon nanomaterial precursor composite sheet 246 along the processing path following forming table 240 and are configured to dry carbon nanomaterial precursor composite sheet 246 (e.g., remove liquid 236 remaining in carbon nanomaterial precursor composite sheet 246) and form carbon nanomaterial composite sheet 202. Second rollers 250 may be guide rollers, nip rollers, pinch rollers or the like configured to pull, direct or guide carbon nanomaterial precursor composite sheet 246 along the processing path. Second rollers 250 may also be configured to compress carbon nanomaterial precursor composite sheet 246 and form carbon nanomaterial composite sheet 202. Second rollers 250 may be heated rollers configured to increase the temperature of carbon nanomaterial precursor composite sheet 246, for example, to dry carbon nanomaterial precursor composite sheet 246 while carbon nanomaterial precursor composite sheet 246 is being compressed by second rollers 250. While only a single opposed pair of second rollers 250 is illustrated in Figs. 2 and 5 by example, those skilled in the art will recognize that multiple pairs of second rollers 250 may be disposed along the processing path to incrementally compress (e.g., by between approximately 0.5 mil to approximately 1.0 mil) in multiple stages.

Applying pressure and/or heat to carbon nanomaterial precursor composite sheet 246 (e.g., combination of carbon nanomaterial structure 242 and carrier layer 204) (block 114) may further intersperse and integrate carbon nanomaterials 226 with carrier layer 204, for example, bonding carbon nanomaterial structure 242 and carrier layer 204 together (block 122).

Following the applying of pressure and/or heat step (block 114) (Fig. 1), carbon nanomaterial composite sheet 202 may be rolled into a roll of carbon nanomaterial composite sheet 202 (generally referred to herein as roll 252).

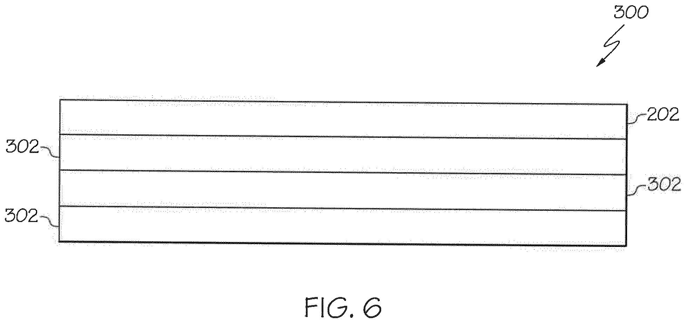

Referring to Fig. 5, and with reference to Fig. 4, in one example implementation, carrier layer 204 may also include protective film 216. Protective film 216 may protect carbon nanomaterial composite sheet 202, for example, when rolled into roll 252. Protective film 216 is removed from carbon nanomaterial composite sheet 202 prior to use of carbon nanomaterial composite sheet 202 in a particular application, for example, when used to make composite structure 300 (Fig. 6). Protective film 216 may also be referred to as a protective layer or release film.

As one example, protective film 216 may be provided as (or take the form of) a sheet of protective film 216 (generally referred to herein as sheet 222). As one specific, non-limiting example, protective film 216 may be made of a polytetrafluoroethylene glass material, such as ARMALON™ polytetrafluoroethylene glass laminate.

As one example, system 200 may include a continuous sheet 222 rolled into a roll of protective film 216 (generally referred to herein as roll 220). As one example, protective film 216 may be releasably coupled to carrier layer 204 (e.g., carbon fiber veil 210).

First rollers 224 may be configured to pull carrier layer 204 of off roll 208 and protective film 216 off of roll 220 and direct or guide carrier layer 204 and protective film 216 along the processing path. First rollers 224 may also be configured compress sheet 206 and sheet 222 into intimate contact.

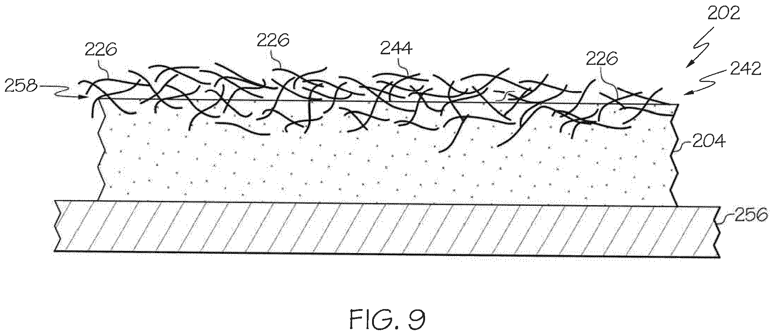

Referring to Fig. 9, in one example, carbon nanomaterial composite structure 202 may include dielectric layer 256. Dielectric layer 256 may be coupled to carrier layer 204. As one example, dielectric layer 256 may be applied to carrier layer 204 before the overlaying step of slurry 238 of carbon nanomaterials 226 and liquid 236 (block 108). As illustrated in Fig. 9, carrier layer 204 may be disposed between dielectric layer 256 and carbon nanomaterial structure 242. As one example, application of dielectric layer 256 to carrier layer 204 may be similar to the process described herein above with reference to application of protective film 216. However, dielectric layer 256 may not be removed from carrier layer 204. In one example, carbon nanomaterial composite structure 202 may include dielectric layer 256 and protective film 216 applied to carrier layer 204. For example, protective film 216 may be applied (e.g., releasably coupled) to dielectric layer 256 (e.g., dielectric layer 256 is disposed between carrier layer 204 and protective film 216. Dielectric layer 256 may be porous or non-porous (e.g., may be made from a porous material or a non-porous material).

Referring to Fig. 6, one example of composite structure 300 is disclosed. In one example, composite structure 300 includes at least one fiber-reinforced polymer layer 302 and carbon nanomaterial composite sheet 202. Carbon nanomaterial composite sheet 202 may include layer 258 of carbon nanomaterial structure 242, and carrier layer 204. Carrier layer 204 may include a porous metalized nonwoven material. Carrier layer 204 may be bonded to carbon nanomaterial structure 242. In one example, carrier layer 204 may be permanently bonded to carbon nanomaterial structure 242. In one example, carbon nanomaterial composite sheet 202 is a laminate. In one example, carbon nanomaterial structure 242 may include a randomly oriented, uniformly distributed structure of carbon nanotubes 228 (or other types carbon nanomaterials 226).

Thus, in one example, composite structure 300 may be a composite laminate. As one example, composite structure 300 may include one or more fiber-reinforced polymer layers 302 (e.g., three fiber-reinforced polymer layers 302 are illustrated in the example of Fig. 6). Each one of fiber-reinforced polymer layers 302 may include a sheet, mat, or ply of reinforcing fibrous material (not explicitly illustrated) bonded together by a polymer matrix (not explicitly illustrated). The fibrous material may include any suitable woven or nonwoven (e.g., knit, braided or stitched) continuous reinforcing fibers or filaments. The polymer matrix material may include any suitable thermoset resin (e.g., epoxy) or thermoplastic.

Various known processes or techniques may be used to make fiber-reinforced polymer layers 302. As one example, each one of fiber-reinforced polymer layers 302 may include a sheet of the reinforcing fibrous material pre-impregnated with the polymer matrix material (e.g., a pre-preg), also known as a dry layup. As one example, each one of fiber-reinforced polymer layers 302 may include a sheet of the reinforcing fibrous material and the polymer matrix material is applied to the reinforcing fibrous material, also known as a wet layup.

Composite structure 300 also includes at least one layer of carbon nanomaterial composite sheet 202. Various known processes or techniques may be used to make composite structure 300. In one example implementation, fiber-reinforced polymer layers 302 and carbon nanomaterial composite sheet 202 may be consecutively laid up, for example, within a mold (not explicitly illustrated). Fiber-reinforced polymer layers 302 and carbon nanomaterial composite sheet 202 may be co-cured to form composite structure 300. As one example, and as illustrated in Fig. 6, carbon nanomaterial composite sheet 202 is an outermost layer of the composite lay-up (e.g., defining an exterior surface layer of composite structure 300). As one example, carbon nanomaterial composite sheet 202 is an interior layer of the composite lay-up (e.g., defining an interior layer of composite structure 300).

Composite structure 300 may include any desired three-dimensional ("3D") shape. 3D shape may include various dimensions including a length dimension, a width dimension, a height dimension and/or a cross-sectional dimension of composite structure 300. As one specific, non-limiting example, composite structure 300 may be a skin panel of an aircraft.

Accordingly, the disclosed carbon nanomaterial composite sheet 202 may be integrated into a production process for making composite structure 300. Carbon nanomaterial composite sheet 202 may provide composite structure 300 with effective shielding against EMI and effective lighting strike protection without the need for additional materials.

Composite structure 300 including carbon nanomaterial composite sheet 202 may have broadband EMI shielding effectiveness, which may be particularly beneficial in aerospace applications since each radio frequency ("RF") band may affect electronics and avionics differently. As one example, carbon nanomaterial composite sheet 202 including carrier layer 204 (e.g., carbon fiber veil 210) and carbon nanomaterial structure 242 may be provide effective EMI shielding at medium frequencies (between approximately 100 MHz and approximately 1 GHz) and at high frequencies (greater than approximately 1 GHz). As one example, carbon nanomaterial composite sheet 202 including carrier layer 204 with nickel coating 214 (e.g., nickel coated carbon fiber veil 210) and carbon nanomaterial structure 242 may be provide effective EMI shielding at low frequencies (less than approximately 100 MHz), medium frequencies (between approximately 100 MHz and approximately 1 GHz), and at high frequencies (greater than approximately 1 GHz).

Use of a dielectric material as carrier layer 204 or dielectric layer 256 coupled to carrier layer 204 may provide a barrier to the underlying composite structure 300 for lightning protection by, for example, keeping the lightning current at the surface in the event of a lightning strike and allowing carbon nanomaterial composite sheet 202 to conduct away the energy before it gets into and causes damage to the underlying composite structure 300

In various examples, the materials selected for carbon nanomaterial composite sheet 202 may be selected to provide a desired EMI shielding effectiveness (in decibels) ("dB") for a particular frequency or range of frequencies. As one example, carbon nanomaterial structure 242 (formed from the network of entangled carbon nanomaterials 226) may provide carbon nanomaterial composite sheet 202 with effective EMI shielding at medium and high frequencies. A conductive carrier layer 204 (e.g., formed from a conductive material or a metallic coated material) may provide carbon nanomaterial composite sheet 202 with effective EMI shielding at low frequencies. Accordingly, carbon nanomaterial composite sheet 202 including carrier layer 204 (e.g., carbon fiber veil 210) with metallic coating 254 (e.g., nickel coating 214) and carbon nanomaterial structure 242 may be provide effective EMI shielding at low frequencies, medium frequencies, and high frequencies. Nickel used as metallic coating 254 may beneficially provide the highest shielding performance or effectiveness at low frequencies.

Without being limited to any particular theory, reducing the resistance of carrier layer 204 may equate to an increase in conductivity and, thus, an increase in EMI shielding effectiveness, for example, particularly at low frequencies.

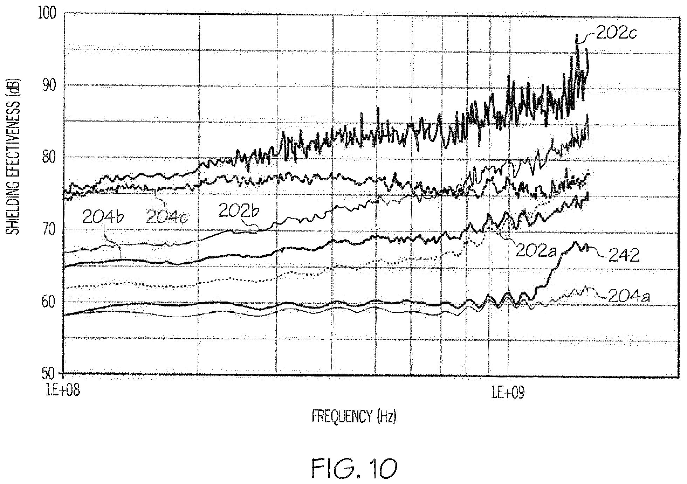

As illustrated in Fig. 10, the EMI shielding effectiveness of various material configurations of composite sheet 202 are shown. Fig. 10 shows examples of the shielding effectiveness of first carrier layer 204a, carbon nanomaterial structure 242, first carbon nanomaterial composite sheet 202a, second carrier layer 204b, second carbon nanomaterial composite sheet 202b, third carrier layer 204c, and third carbon nanomaterial composite sheet 202c.

As one example, carbon nanomaterial structure 242 includes an entangled network of carbon nanomaterials 226. Carbon nanomaterial structure 242 may provide a shielding effectiveness ranging from approximately 58 dB to approximately 62 dB over frequencies ranging from approximately 100 MHz to approximately 1 GHz.

As one example, first carrier layer 204a includes a conductive material. The conductive material may include a conductive material layer, a conductive material layer having a metallic coating (e.g., nickel coating), or a non-conductive material layer having a metallic coating. First carrier layer 204a may have a resistance of approximately 0.1 ohm. First carrier layer 204a may provide a shielding effectiveness ranging from approximately 58 dB to approximately 68 dB over frequencies ranging from approximately 100 MHz to approximately 1 GHz.

As one example, first carbon nanomaterial composite sheet 202a includes first carrier layer 204a and carbon nanomaterial structure 242. First carbon nanomaterial composite sheet 202a may provide a shielding effectiveness ranging from approximately 61 dB to approximately 78 dB over frequencies ranging from approximately 100 MHz to approximately 1 GHz.

As one example, second carrier layer 204b includes a conductive material. The conductive material may include a conductive material layer, a conductive material layer having a metallic coating (e.g., nickel coating), or a non-conductive material layer having a metallic coating. Second carrier layer 204b may have a resistance of approximately 0.04 ohm. Second carrier layer 204b may provide a shielding effectiveness ranging from approximately 65 dB to approximately 75 dB over frequencies ranging from approximately 100 MHz to approximately 1 GHz.

As one example, second carbon nanomaterial composite sheet 202b includes second carrier layer 204b and carbon nanomaterial structure 242. Second carbon nanomaterial composite sheet 202b may provide a shielding effectiveness ranging from approximately 67 dB to approximately 86 dB over frequencies ranging from approximately 100 MHz to approximately 1 GHz.

As one example, third carrier layer 204c includes a conductive material. The conductive material may include a conductive material layer, a conductive material layer having a metallic coating (e.g., nickel coating), or a non-conductive material layer having a metallic coating. Third carrier layer 204c may have a resistance of approximately 0.02 ohm. Third carrier layer 204c may provide a shielding effectiveness ranging from approximately 74 dB to approximately 78 dB over frequencies ranging from approximately 100 MHz to approximately 1 GHz.

As one example, third carbon nanomaterial composite sheet 202c includes third carrier layer 204c and carbon nanomaterial structure 242. Third carbon nanomaterial composite sheet 202c may provide a shielding effectiveness ranging from approximately 65 dB to approximately 97 dB over frequencies ranging from approximately 100 MHz to approximately 1 GHz.

In one variation, the disclosed carbon nanomaterial composite sheet may be an elastomeric carbon nanomaterial composite sheet. In other words, the disclosed elastomeric carbon nanomaterial composite sheet is a carbon nanomaterial composite sheet with the addition of an elastomer material. With reference to Fig. 3, that is to say the disclosed carbon nanomaterial composite sheet 202 may be an elastomeric carbon nanomaterial composite sheet when the carbon nanomaterial composite sheet 202 includes a polymer layer 262, a polymer encapsulating layer 264 and/or a prepreg material 266, and the polymer layer 262, the polymer encapsulating layer 264 and/or the prepreg material 266 includes an elastomer material.

Disclosed are composite structures and structural assemblies that incorporate the disclosed elastomeric carbon nanomaterial composite sheet. Various composite structures and various structural assemblies may be formed that incorporate the disclosed elastomeric carbon nanomaterial composite sheet without departing from the scope of the present disclosure.

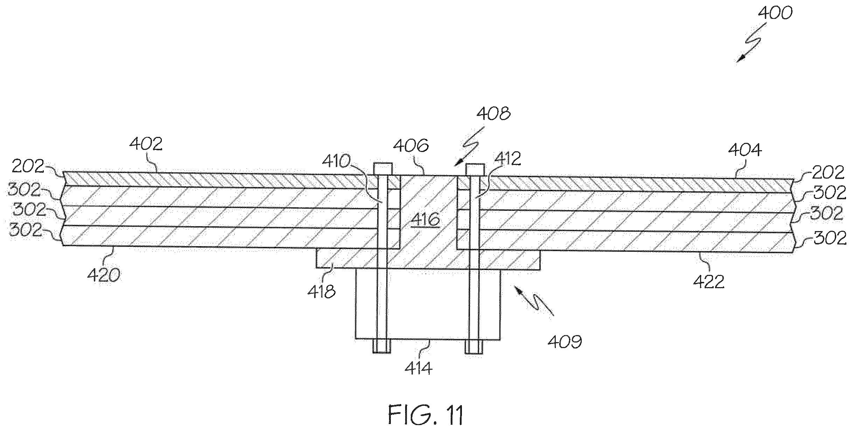

Referring to Fig. 11, one example of a structural assembly, generally designated 400, may include a first structural member 402, a second structural member 404 and a composite structure 406. The first structural member 402 may be spaced apart from the second structural member 404 to define a gap 408 therebetween. The composite structure 406 may be positioned in the gap 408 between the first structural member 402 and the second structural member 404.

A first mechanical fastener 410, such a nut and bolt, a screw, a pin, a rivet or the like, may secure the first structural member 402 of the structural assembly 400 to the composite structure 406 and, optionally, also to an underlying substructure 414 (e.g., an aircraft rib, stringer, frame or the like). A second mechanical fastener 412, such a nut and bolt, a screw, a pin, a rivet or the like, may secure the second structural member 404 to the composite structure 406 and, optionally, also to the underlying substructure 414.

The first structural member 402 and the second structural member 404 of the structural assembly 400 may be various structures (e.g., aircraft structures or the like) desired to be joined together. As a general example, the first structural member 402 and the second structural member 404 may be composite panels, such as composite panels forming the outer skin of an aircraft fuselage. As a specific example, the first structural member 402 and the second structural member 404 may be composite panels having the composite structure 300 shown in Fig. 6, including an outermost layer including a carbon nanomaterial composite sheet 202 and plural fiber-reinforced polymer layers 302.

Still referring to Fig. 11, the composite structure 406 may be a gasket positioned in the gap 408 between the first structural member 402 and the second structural member 404, as well as in the gap 409 between the first and second structural members 402, 404 and the underlying substructure 414. In one particular configuration, the composite structure 406 may include a body portion 416 and a flange portion 418 connected to, and protruding from, the body portion 416. The body portion 416 of the composite structure 406 may be sized and shaped to be received in the gap 408 between the first structural member 402 and the second structural member 404. The flange portion 418 of the composite structure 406 may be sized and shaped to be received in the gap 409 between the undersurfaces 420, 422 of the first and second structural members 402, 404 and the underlying substructure 414.

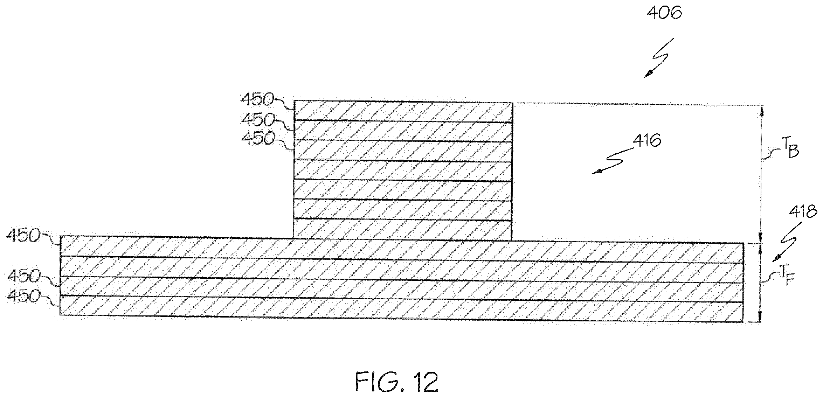

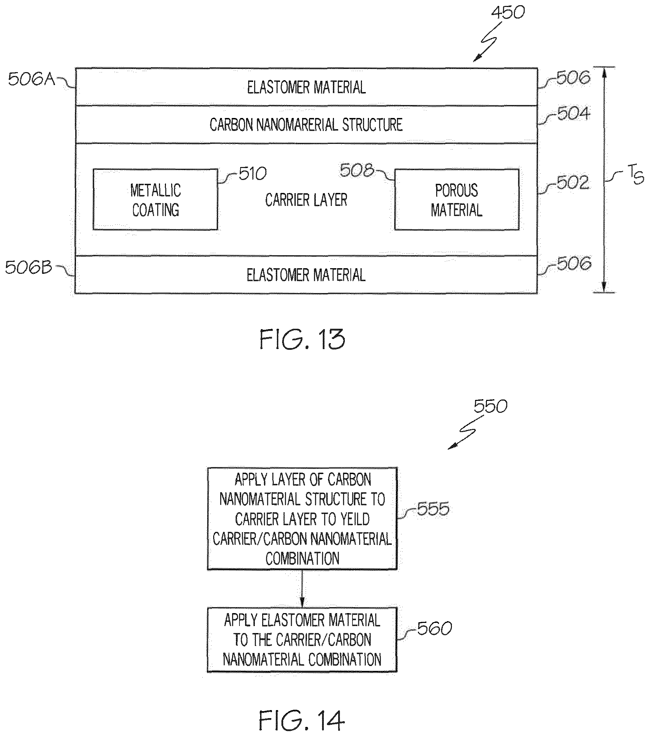

As shown in Fig. 12, the disclosed composite structure 406 may be formed from a plurality of the disclosed elastomeric carbon nanomaterial composite sheets 450 that have been laid up and cured. Each elastomeric carbon nanomaterial composite sheet 450 may have a cross-sectional thickness **T_{S}** (Fig. 13). Therefore, the total number of elastomeric carbon nanomaterial composite sheets 450 used to form the composite structure 406 may depend on, for example, the cross-sectional thickness **T_{S}** of each elastomeric carbon nanomaterial composite sheet 450, the desired cross-sectional thickness **T_{B}** of the body portion 416 of the composite structure 406 and the desired cross-sectional thickness **T_{F}** of the flange portion 418 of the composite structure 406. For example (and without limitation), when each elastomeric carbon nanomaterial composite sheet 450 has a cross-sectional thickness **T_{S}** of about 0.0061 inches, twenty-eight elastomeric carbon nanomaterial composite sheets 450 may yield a body portion 416 having a cross-sectional thickness **T_{B}** of about 0.176 inches and five elastomeric carbon nanomaterial composite sheets 450 may yield a flange portion 418 having a cross-sectional thickness **T_{F}** of about 0.030 inches.

Referring to Fig. 13, the disclosed elastomeric carbon nanomaterial composite sheet 450 may include a carrier layer 502, a carbon nanomaterial structure 504 and an elastomer material 506. The carrier layer 502 and the carbon nanomaterial structure 504 may be impregnated with the elastomer material 506.

The carrier layer 502 of the elastomeric carbon nanomaterial composite sheet 450 may be formed from a porous material 508 that is the same as (or similar to) the porous material forming carrier layer 204 (Fig. 3) of the disclosed carbon nanomaterial composite sheet 202 (Fig. 3). Various porous materials suitable for forming the carrier layer 502 are disclosed herein. As one general, non-limiting example, the porous material 508 forming the carrier layer 502 may be nonwoven. As one specific, non-limiting example, the porous material 508 forming the carrier layer 502 may be (or may include) carbon fiber (e.g., a carbon fiber veil).

The carrier layer 502 of the elastomeric carbon nanomaterial composite sheet 450 may include a metallic coating 510 applied to the porous material 508. Various metallic materials suitable for use as (or in) the metallic coating 510 are disclosed herein. As one specific, non-limiting example, the metallic coating 510 may be (or may include) nickel.

The carbon nanomaterial structure 504 of the elastomeric carbon nanomaterial composite sheet 450 may be applied to the carrier layer 502. For example, the carbon nanomaterial structure 504 may be applied to the carrier layer 502 such that at least a portion of the carbon nanomaterials of the carbon nanomaterial structure 504 are interspersed through a thickness of the carrier layer 502 and are entangled with the carrier layer 502 such that the carbon nanomaterial structure 504 is permanently bonded to the carrier layer 502. The composition of the carbon nanomaterial structure 504 (e.g., the carbon nanomaterials) is described in greater detail herein in connection with the carbon nanomaterial structure 242 (Fig. 3) of carbon nanomaterial composite sheet 202 (Fig. 3). Likewise, the method for applying the carbon nanomaterial structure 504 to the carrier layer 502 is described in greater detail herein in connection with the carbon nanomaterial structure 242 being applied to carrier layer 204 (Fig. 3) (see, e.g., Figs. 2 and 5).

The carrier layer 502 and the carbon nanomaterial structure 504 (collectively, a carrier/carbon nanomaterial combination) may be impregnated with the elastomer material 506. For example, as is described in greater detail herein, the carrier layer 502 and the carbon nanomaterial structure 504 may be sandwiched between a first layer 506A of the elastomer material 506 and a second layer 506B of the elastomer material 506. Therefore, the elastomer material 506 may function as the resin matrix of the disclosed elastomeric carbon nanomaterial composite sheet 450.

The composition of the elastomer material 506 of the elastomeric carbon nanomaterial composite sheet 450 may vary without departing from the scope of the present disclosure. Depending on the end application, factors such as maximum service temperature and chemical resistance (e.g., to fuel and/or hydraulic fluid) may be considered when selecting an elastomer material for the elastomeric carbon nanomaterial composite sheet 450.

Viscoelasticity may also be a consideration when selecting an elastomer material for the elastomeric carbon nanomaterial composite sheet 450. In one expression, the elastomer material 506 may be viscoelastic polymer capable of reversibly extending at least 5 percent from its original configuration. In another expression, the elastomer material 506 may be viscoelastic polymer capable of reversibly extending at least 10 percent from its original configuration. In another expression, the elastomer material 506 may be viscoelastic polymer capable of reversibly extending at least 50 percent from its original configuration. In another expression, the elastomer material 506 may be viscoelastic polymer capable of reversibly extending at least 100 percent from its original configuration.

Several general examples of elastomer materials suitable for use as the elastomer material 506 of the disclosed elastomeric carbon nanomaterial composite sheet 450 include, without limitation, natural rubber, synthetic rubbers and fluoroelastomers. Those skilled in the art will appreciate that elastomer materials suitable for use in the disclosed elastomeric carbon nanomaterial composite sheet 450 may be thermosetting (a thermoset elastomer material) or thermoplastic (a thermoplastic elastomer material). One specific, non-limiting example of an elastomer material suitable for use as the elastomer material 506 of the disclosed elastomeric carbon nanomaterial composite sheet 450 is nitrile rubber. Other specific examples of elastomer materials suitable for use as the elastomer material 506 of the disclosed elastomeric carbon nanomaterial composite sheet 450 includes, without limitation, VITON™ fluoroelastomer, which is commercially available from The Chemours Company of Wilmington, Delaware, TECNOFLON® fluoroelastomer, which is commercially available from Solvay of Bruxelles, Belgium, and AFLAS® fluoroelastomer, which is commercially available from Asahi Glass Company of Tokyo, Japan.

Various methods may be used to manufacture the disclosed elastomeric carbon nanomaterial composite sheet 450. Referring to Fig. 14, one example method, generally designated 550, for manufacturing an elastomeric carbon nanomaterial composite sheet may begin at Block 555 with the step of applying a layer of a carbon nanomaterial structure to a carrier layer to yield a carrier/carbon nanomaterial combination. The carrier layer may include a porous material and a metallic coating applied to the porous material. The step (Block 555) of applying a layer of a carbon nanomaterial structure to a carrier layer is shown in Figs. 2 and 5 and described herein.

At Block 560, an elastomer material may be applied to the carrier/carbon nanomaterial combination. Various techniques may be used to apply an elastomer material to the carrier/carbon nanomaterial combination.

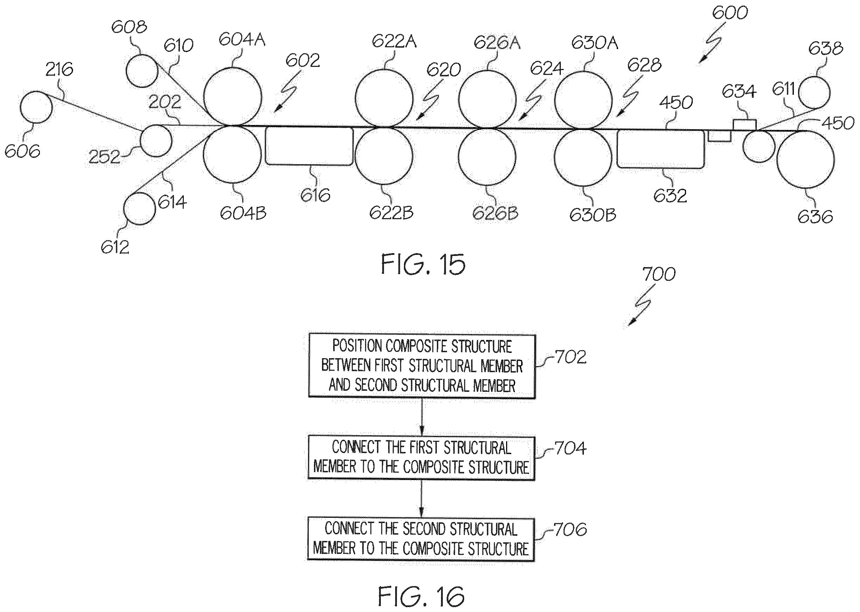

Referring to Fig. 15, as one example, the step (Block 560 of Fig. 14) of applying an elastomer material to the carrier/carbon nanomaterial combination may be performed by elastomer material application system 600. Elastomer material application system 600 may be supplied with the roll 252 of carbon nanomaterial composite sheet 202 (carrier/carbon nanomaterial combination; no polymer layer 262 or the like) produced in Fig. 5. The roll 252 may be unwound to supply the carbon nanomaterial composite sheet 202 into the nip 602 defined by compaction rollers 604A, 604B. The protective film 216, if present, may be separated from the carbon nanomaterial composite sheet 202 and wound onto take-up roll 606.

A first elastomer material roll 608 may be unwound to supply a first sheet 610 of elastomer material 506 (Fig. 13) and optional first backing/release film 611 into the nip 602. The first sheet 610 may be applied over the carbon nanomaterial composite sheet 202. Optionally, a second elastomer material roll 612 may be unwound to supply a second sheet 614 of elastomer material 506 (and optional second backing/release film (not shown)) into the nip 602. The second sheet 614 may be applied under the carbon nanomaterial composite sheet 202. Therefore, the carbon nanomaterial composite sheet 202 may be sandwiched between the first sheet 610 of elastomer material 506 and the second sheet 614 of elastomer material 506. The combination of sheet 202 and elastomer material 506 may be sandwiched between the first and second backing/release film 611.

The sheets 202, 610, 614 may exit the nip 602 and may be heated by hot plate 616. The heated sheets 202,, 610, 614 may then pass through a series of nips 620, 624, 628 defined by compaction rollers 622A, 622B, 626A, 626B, 630A, 630B. The combination of heat and pressure (supplied by nips 620, 624, 628) may facilitate impregnating sheet 202 with the elastomer material 506 of sheets 610, 614, thereby yielding the disclosed elastomeric carbon nanomaterial composite sheet 450.

The elastomeric carbon nanomaterial composite sheet 450 may exit nip 628 and may be cooled by cold plate 632. The resulting cooled elastomeric carbon nanomaterial composite sheet 450 may optionally be trimmed by slitter 634, and the resulting trimmed and cooled elastomeric carbon nanomaterial composite sheet 450 may be wound onto roller 636. The first backing/release film 611 may be separated and wound onto take-up roll 638 prior to roller 636.

Also disclosed is a method for joining a first structural member with a second structural member. Referring to Fig. 16, one example of the disclosed method, generally designated 700, may begin at Block 702 with the step of positioning a composite structure between the first structural member and the second structural member. The composite structure may include an elastomeric carbon nanomaterial composite sheet including a carrier layer that includes a porous material and a metallic coating applied to the porous material, a layer of a carbon nanomaterial structure applied to the carrier layer, the carbon nanomaterial structure including carbon nanomaterials, and an elastomer material, wherein the carrier layer and the carbon nanomaterial structure are impregnated with the elastomer material. At Block 704, the first structural member may be connected to the composite structure. At Block 706, the second structural member may be connected to the composite structure.

Accordingly, the disclosed elastomeric carbon nanomaterial composite sheet and composite structures formed therefrom facilitate mechanically joining structural members. However, because of the composition of composite structures formed from the disclosed elastomeric carbon nanomaterial composite sheet, and particularly the planar (x-y plane) electrical conductivity associated with such composition/structure, such composite structures also facilitate electromagnetically joining the structural members such that two joined structural members electromagnetically behave as a single, integral panel.

Examples of the present disclosure may be described in the context of aircraft manufacturing and service method 1100 as shown in Fig. 7 and aircraft 1200 as shown in Fig. 8.

During pre-production, the illustrative method 1100 may include specification and design, as shown at block 1102, of aircraft 1200, which may include, for example, design of a carbon nanomaterial composite sheet, and material procurement, as shown at block 1104. During production, component and subassembly manufacturing, as shown at block 1106, and system integration, as shown at block 1108, of aircraft 1200 may take place. Production of carbon nanomaterial composite sheets and use of carbon nanomaterial composite sheets in composite structures, as described herein, may be accomplished as a portion of the production, component and subassembly manufacturing step (block 1106) and/or as a portion of the system integration (block 1108). Thereafter, aircraft 1200 may go through certification and delivery, as shown block 1110, to be placed in service, as shown at block 1112. While in service, aircraft 1200 may be scheduled for routine maintenance and service, as shown at block 1114. Routine maintenance and service may include modification, reconfiguration, refurbishment, etc. of one or more systems of aircraft 1200.

Each of the processes of illustrative method 1100 may be performed or carried out by a system integrator, a third party, and/or an operator (e.g., a customer). For the purposes of this description, a system integrator may include, without limitation, any number of aircraft manufacturers and major-system subcontractors; a third party may include, without limitation, any number of vendors, subcontractors, and suppliers; and an operator may be an airline, leasing company, military entity, service organization, and so on.

As shown in Fig. 8, aircraft 1200 produced by illustrative method 1100 may include airframe 1202, for example, having structural assemblies including the disclosed carbon nanomaterial composite sheets (e.g., elastomeric carbon nanomaterial composite sheets), and a plurality of high-level systems 1204 and interior 1206. Examples of high-level systems 1204 include one or more of propulsion system 1208, electrical system 1210, hydraulic system 1212 and environmental system 1214. Any number of other systems may be included. Although an aerospace example is shown, the principles disclosed herein may be applied to other industries, such as the automotive industry, the marine industry, and the like.

The apparatus and methods shown and described herein may be employed during any one or more of the stages of the manufacturing and service method 1100. For example, components or subassemblies corresponding to component and subassembly manufacturing (block 1106) may be fabricated or manufactured in a manner similar to components or subassemblies produced while aircraft 1200 is in service (block 1112). Also, one or more examples of the apparatus, methods, or combination thereof may be utilized during production stages (blocks 1108 and 1110), for example, by increasing the effective EMI shielding and/or lightning protection of aircraft 1200. Similarly, one or more examples of the apparatus, methods, or a combination thereof, may be utilized, for example and without limitation, while aircraft 1200 is in service (block 1112) and during maintenance and service stage (block 1114).

Although various examples of the disclosed carbon nanomaterial composite sheet and associated composite structures and methods are shown and described, modifications may occur to those skilled in the art upon reading the specification. The present application includes such modifications and is limited only by the scope of the claims.

## Claims

1. A composite structure (406) comprising:
an elastomeric carbon nanomaterial composite sheet (450) comprising:
a carrier layer (502) comprising a porous material (508) and a metallic coating (510) applied to said porous material (508);
a layer of a carbon nanomaterial structure (504) applied to said carrier layer (502), said carbon nanomaterial structure (504) comprising carbon nanomaterials (226); and
an elastomer material (506), wherein said carrier layer (502) and said carbon nanomaterial structure (504) arc impregnated with said elastomer material (506), wherein the composite structure (406) is configured as a gasket.

2. The composite structure (406) of Claim 1 comprising a plurality of said elastomeric carbon nanomaterial composite sheets (450).

3. The composite structure of any of Claims 1 to 2 wherein said gasket comprises a body portion (416) and a flange portion (418) connected to said body portion (416).

4. The composite structure (406) of any of Claims 1 to 3 wherein said porous material (508) is nonwoven.

5. The composite structure (406) of any of Claims 1 to 4 wherein said porous material (508) comprises carbon fiber.

6. The composite structure (406) of any of Claims 1 to 5 wherein metallic coating (510) comprises nickel.

7. The composite structure (406) of any of Claims 1 to 6 wherein at least a portion of said carbon nanomaterials (226) of said carbon nanomaterial structure (504) are interspersed through a thickness of said carrier layer (502) and are entangled with said carrier layer (502) such that said carbon nanomaterial structure (504) is permanently bonded to said carrier layer (502).

8. The composite structure (406) of any of Claims 1 to 7 wherein said carbon nanomaterial structure (504) comprises a randomly oriented, uniformly distributed structure of said carbon nanomaterials (226).

9. The composite structure (406) of any of Claims 1 to 8 wherein said carbon nanomaterials (226) comprise at least one of carbon nanotubes (228), carbon nanoparticles (232), carbon nanospheres (230) and graphene (234).

10. The composite structure of any of Claims 1 to 9 wherein said elastomer material is a synthetic rubber, a nitrile rubber, or a fluoroelastomer.

11. A method (550) for manufacturing an elastomeric carbon nanomaterial composite sheet (450) included in a composite structure (406), said method comprising:
applying (555) a layer of a carbon nanomaterial structure (504) to a carrier layer (502) to yield a carrier/carbon nanomaterial combination, said carrier layer (502) comprising a porous material (508) and a metallic coating (510) applied to said porous material (508); and
applying (560) an elastomer material (506) to said carrier/carbon nanomaterial combination to obtain the elastomeric carbon nanomaterial composite sheet (450); and
including the elastomeric carbon nanomaterial composite sheet (450) in a composite structure (406), wherein the composite structure (406) is configured as a gasket.

12. The method of Claim 11 wherein said elastomer material (506) is in sheet form, and wherein said applying said elastomer material (506) to said carrier/carbon nanomaterial combination comprises laying said elastomer material (506) in said sheet form over said carrier/carbon nanomaterial combination to form a layup.

13. The method of any of Claims 11 to 12 wherein said applying said elastomer material (506) to said carrier/carbon nanomaterial combination comprises at least one of heating said layup and compacting said layup.

14. The method of any of Claims 11 to 13 wherein said applying said elastomer material (506) to said carricr/carbon nano material combination comprises sandwiching said carrier/carbon nanomaterial combination between a first layer of said elastomer material (506) and a second layer of said elastomer material (506).

## Patentansprüche

1. Verbundstruktur (406), die aufweist:
eine elastomere Karbonnanomaterial-Verbundschicht (450), die aufweist:
eine Trägerschicht (502), die ein poröses Material (508) und eine metallische Beschichtung (510) aufweist, die auf das poröse Material (508) aufgebracht ist;
eine Schicht aus einer Karbonnanomaterialstruktur (504), die auf die Trägerschicht (502) aufgebracht ist, wobei die Karbonnanomaterialstruktur (504) Karbonnanomaterialien (226) aufweist; und
ein elastomeres Material (506), wobei die Trägerschicht (502) und die Karbonnanomaterialstruktur (504) mit dem elastomeren Material (506) imprägniert sind,
wobei die Verbundstruktur (406) als Dichtung eingerichtet ist.

2. Verbundstruktur (406) nach Anspruch 1, die eine Vielzahl der elastomeren Karbonnanomaterial-Verbundschichten (450) aufweist.

3. Verbundstruktur nach einem der Ansprüche 1 bis 2, wobei die Dichtung einen Körperabschnitt (416) und einen Flanschabschnitt (418) aufweist, der mit dem Körperabschnitt (416) verbunden ist.

4. Verbundstruktur (406) nach einem der Ansprüche 1 bis 3, wobei das poröse Material (508) ein Vlies ist.

5. Verbundstruktur (406) nach einem der Ansprüche 1 bis 4, wobei das poröse Material (508) Karbonfasern aufweist.

6. Verbundstruktur (406) nach einem der Ansprüche 1 bis 5, wobei die metallische Beschichtung (510) Nickel aufweist.

7. Verbundstruktur (406) nach einem der Ansprüche 1 bis 6, wobei zumindest ein Teil der Karbonnanomaterialien (226) der Karbonnanomaterialstruktur (504) eine Dicke der Trägerschicht (502) durchsetzt und derart mit der Trägerschicht (502) verwirrt ist, dass die Karbonnanomaterialstruktur (504) permanent an die Trägerschicht (502) gebunden ist.

8. Verbundstruktur (406) nach einem der Ansprüche 1 bis 7, wobei die Karbonnanomaterialstruktur (504) eine zufällig orientierte, gleichförmig verteilte Struktur der Karbonnanomaterialien (226) aufweist.

9. Verbundstruktur (406) nach einem der Ansprüche 1 bis 8, wobei die Karbonnanomaterialien (226) Karbonnanoröhren (228), Karbonnanopartikel (232), Karbonnanosphären (230) und/oder Graphen (234) aufweisen.

10. Verbundstruktur nach einem der Ansprüche 1 bis 9, wobei das elastomere Material ein synthetischer Gummi, ein Nitrilgummi oder ein Fluorelestomer ist.

11. Verfahren (550) zum Herstellen einer elastomeren Karbonnanomaterial-Verbundschicht (450), die in einer Verbundstruktur (406) umfasst ist, wobei das Verfahren aufweist:
Aufbringen (555) einer Schicht aus einer Karbonnanomaterialstruktur (504) auf eine Trägerschicht (502), um eine Träger/Karbonnanomaterial-Kombination zu erhalten, wobei die Trägerschicht (502) ein poröses Material (508) und eine metallische Beschichtung (510) aufweist, die auf das poröse Material (508) aufgebracht ist; und
Aufbringen (560) eines elastomeren Materials (506) auf die Träger/Karbonnanomaterial-Kombination, um die elastomere Karbonnanomaterial-Verbundschicht (450) zu erhalten; und
Einschließen der elastomeren Karbonnanomaterial-Verbundschicht (450) in einer Verbundstruktur (406), wobei die Verbundstruktur (406) als Dichtung eingerichtet ist.

12. Verfahren nach Anspruch 11, wobei das elastomere Material (506) schichtförmig ist, und wobei das Aufbringen des elastomeren Materials (506) auf die Träger/ Karbonnanomaterial-Kombination ein Legen des elastomeren Materials (506) in der Schichtform über die Träger/Karbonnanomaterial-Kombination aufweist, um eine Auflegung zu bilden.

13. Verfahren nach einem der Ansprüche 11 bis 12, wobei das Aufbringen des elastomeren Materials (506) auf die Träger/Karbonnanomaterial-Kombination ein Erwärmen der Auflegung und/oder Verdichten der Auflegung aufweist.

14. Verfahren nach einem der Ansprüche 11 bis 13, wobei das Aufbringen des elastomeren Materials (506) auf die Träger/Karbonnanomaterial-Kombination ein Dazwischenfügen der Träger/Karbonnanomaterial zwischen eine erste Schicht des elastomeren Materials (506) und eine zweite Schicht des elastomeren Materials (506) aufweist.

## Revendications

1. Structure composite (406) comprenant :
une feuille composite de nanomatériau de carbone élastomérique (450) comprenant :
une couche support (502) comprenant un matériau poreux (508) et un revêtement métallique (510) appliqué audit matériau poreux (508) ;
une couche d'une structure de nanomatériau de carbone (504) appliquée à ladite couche support (502), ladite structure de nanomatériau de carbone (504) comprenant des nanomatériaux de carbone (226) ; et
un matériau d'élastomère (506), ladite couche support (502) et ladite structure de nanomatériau de carbone (504) étant imprégnées avec ledit matériau d'élastomère (506),
la structure composite (406) étant configurée comme un joint.

2. Structure composite (406) selon la revendication 1 comprenant une pluralité desdites feuilles composites de nanomatériau de carbone élastomériques (450).

3. Structure composite selon l'une quelconque des revendications 1 et 2, ledit joint comprenant une partie de corps (416) et une partie de rebord (418) connectée à ladite partie de corps (416).

4. Structure composite (406) selon l'une quelconque des revendications 1 à 3, ledit matériau poreux (508) étant non-tissé.

5. Structure composite (406) selon l'une quelconque des revendications 1 à 4, ledit matériau poreux (508) comprenant une fibre de carbone.

6. Structure composite (406) selon l'une quelconque des revendications 1 à 5, ledit revêtement métallique (510) comprenant du nickel.

7. Structure composite (406) selon l'une quelconque des revendications 1 à 6, au moins une partie desdits nanomatériaux de carbone (226) de ladite structure de nanomatériau de carbone (504) étant intercalée à travers une épaisseur de ladite couche support (502) et étant enchevêtrée avec ladite couche support (502) de sorte que ladite structure de nanomatériau de carbone (504) soit liée de manière permanente à ladite couche support (502).

8. Structure composite (406) selon l'une quelconque des revendications 1 à 7, ladite structure de nanomatériau de carbone (504) comprenant une structure orientée de manière aléatoire, distribuée de manière uniforme desdits nanomatériaux de carbone (226).

9. Structure composite (406) selon l'une quelconque des revendications 1 à 8, lesdits nanomatériaux de carbone (226) comprenant au moins l'un parmi des nanotubes de carbone (228), des nanoparticules de carbone (232), des nanosphères de carbone (230) et du graphène (234).

10. Structure composite selon l'une quelconque des revendications 1 à 9, ledit matériau d'élastomère étant un caoutchouc synthétique, un caoutchouc au nitrile, ou un fluoroélastomère.

11. Procédé (550) pour la fabrication d'une feuille composite de nanomatériau de carbone élastomérique (450) incluse dans une structure composite (406), ledit procédé comprenant :
l'application (555) d'une couche d'une structure de nanomatériau de carbone (504) à une couche support (502) pour donner une combinaison de nanomatériau de carbone/support, ladite couche support (502) comprenant un matériau poreux (508) et un revêtement métallique (510) appliqué audit matériau poreux (508) ; et
l'application (560) d'un matériau d'élastomère (506) à ladite combinaison de nanomatériau de carbone/support pour obtenir la feuille composite de nanomatériau de carbone élastomérique (450) ; et
l'inclusion de la feuille composite de nanomatériau de carbone élastomérique (450) dans une structure composite (406), la structure composite (406) étant configurée comme un joint.

12. Procédé selon la revendication 11, ledit matériau d'élastomère (506) étant sous la forme d'une feuille, et ladite application dudit matériau d'élastomère (506) à ladite combinaison de nanomatériau de carbone/support comprenant le dépôt d'une couche dudit matériau d'élastomère (506) dans ladite forme de feuille sur ladite combinaison de nanomatériau de carbone/support pour former une superposition.

13. Procédé selon l'une quelconque des revendications 11 et 12, ladite application dudit matériau d'élastomère (506) à ladite combinaison de nanomatériau de carbone/support comprenant au moins l'un parmi le chauffage de ladite superposition et le compactage de ladite superposition.

14. Procédé selon l'une quelconque des revendications 11 à 13, ladite application dudit matériau d'élastomère (506) à ladite combinaison de nanomatériau de carbone/support comprenant la prise en sandwich de ladite combinaison de nanomatériau de carbone/support entre une première couche dudit matériau d'élastomère (506) et une deuxième couche dudit matériau d'élastomère (506).
